# EUROPEAN PATENT APPLICATION

(11) **EP 4 718 086 A1**
(43) Date of publication of application: **01.04.2026**
(21) Application number: 24829841.6
(22) Date of filing: 19.02.2024
(51) Int. Cl.: G01R 29/10

(54) **ANTENNA DETECTION CIRCUIT AND METHOD, AND ONBOARD DEVICE AND VEHICLE**

(30) Priority: 28.06.2023 CN 202310790263
(71) Applicant: Shenzhen Yinwang Intelligent Technologies Co., Ltd., Shenzhen, Guangdong 518110 (CN)
(72) Inventor: XING, Xiuqiong, Shenzhen, Guangdong 518129 (CN); WANG, Ye, Shenzhen, Guangdong 518129 (CN)
(74) Representative: MERH-IP Matias Erny Reichl Hoffmann Patentanwälte PartG mbB
(86) International application number: PCT/CN2024/077629
(87) International publication number: WO 2025/001182

(57) **Abstract**

An antenna detection circuit and method, an in-vehicle device, and a vehicle are provided, relate to the field of communication technologies, and are used to improve antenna detection accuracy and device safety. The antenna detection circuit includes a controller (10), a switch circuit (20), and an in-position detection circuit (30), an output end of the controller (10) is coupled to a control end of the switch circuit (20), an input end of the switch circuit (20) is configured to be coupled to a power supply, an output end of the switch circuit (20) is coupled to a first input end of the in-position detection circuit (30), and a second input end of the in-position detection circuit (30) is configured to be coupled to an antenna. The controller (10) is configured to control the switch circuit (20) to be turned on or turned off. The switch circuit (20) is configured to turn on or turn off a power supply voltage for supplying power to the in-position detection circuit (30). The in-position detection circuit (30) is configured to: receive the power supply voltage, detect a coupling point voltage of the antenna, and perform two-stage comparison and amplification on the coupling point voltage based on the power supply voltage, to output a first indication signal, where the first indication signal indicates whether the antenna is in position.

## Description

This application claims priority to Chinese Patent Application No. 202310790263.6, filed with the China National Intellectual Property Administration on June 28, 2023 and entitled "ANTENNA DETECTION CIRCUIT AND METHOD, IN-VEHICLE DEVICE, AND VEHICLE", which is incorporated herein by reference in its entirety.

### TECHNICAL FIELD

This application relates to the field of communication technologies, and in particular, to an antenna detection circuit and method, an in-vehicle device, and a vehicle.

### BACKGROUND

Self-driving vehicles (self-driving cars), also referred to as autonomous driving vehicles, computer-driven vehicles, or wheeled mobile robots, are intelligent vehicles that implement self-driving through computer systems. Implementation of autonomous driving technologies depends on continuous development of two types of technologies: perception and decision-making. One of the cores of the perception technologies is a vehicle positioning technology. The vehicle positioning technology provides real-time positioning information for vehicles by leveraging all-weather, global coverage, and other features of a global navigation satellite system (global navigation satellite system, GNSS).

Implementation of the foregoing vehicle positioning function depends on normal operation of an antenna. Therefore, there is a need to perform detection for an abnormality of the antenna, for example, perform detection on an in-position status of the antenna. An existing antenna detection circuit usually compares an in-position detection signal of the antenna with a specific single threshold, to determine the in-position status of the antenna. However, this method may result in an incorrect determination, leading to low accuracy.

### SUMMARY

This application provides an antenna detection circuit and method, an in-vehicle device, and a vehicle, to improve accuracy of antenna status detection.

To achieve the foregoing objective, the following technical solutions are used in embodiments of this application.

According to a first aspect, an antenna detection circuit is provided. The antenna detection circuit includes a controller, a switch circuit, and an in-position detection circuit, an output end of the controller is coupled to a control end of the switch circuit, an input end of the switch circuit is configured to be coupled to a power supply, an output end of the switch circuit is coupled to a first input end of the in-position detection circuit, a second input end of the in-position detection circuit is configured to be coupled to an antenna, and a node coupled to the antenna may also be referred to as a coupling point of the antenna. The controller is configured to control the switch circuit to be turned on or turned off. For example, the controller may be a microcontroller unit. The switch circuit is configured to turn on or turn off a power supply voltage for supplying power to the in-position detection circuit. The in-position detection circuit is configured to: receive the power supply voltage, detect a coupling point voltage of the antenna, and perform two-stage comparison and amplification on the coupling point voltage based on the power supply voltage, to output a first indication signal, where the first indication signal indicates whether the antenna is in position. For example, when the first indication signal is at a low level, the first indication signal may indicate that the antenna is in position; or when the first indication signal is at a high level, the first indication signal may indicate that the antenna is out of position.

In the foregoing technical solution, the antenna detection circuit can detect the coupling point voltage of the antenna, and perform two-stage comparison and amplification on the coupling point voltage based on the power supply voltage, to implement current hysteresis comparison. In this way, an in-position detection current has a hysteresis range. The hysteresis range can raise a criterion for switching an in-position status of the antenna, so that a determining result is more accurate, and safety is higher.

In a possible implementation of the first aspect, the in-position detection circuit includes a sampling circuit, a first-stage operational amplifier circuit, and a second-stage operational amplifier circuit. A first end of the sampling circuit and a first input end of the second-stage operational amplifier circuit are coupled and used as the first input end of the in-position detection circuit, a second end and a third end of the sampling circuit are respectively coupled to a first input end and a second input end of the first-stage operational amplifier circuit, an output end of the first-stage operational amplifier circuit is coupled to a second input end of the second-stage operational amplifier circuit, an output end of the second-stage operational amplifier circuit is used as an output end of the in-position detection circuit, and the second end of the sampling circuit is further configured to be coupled to the antenna. In the foregoing possible implementation, after a current generated by the antenna passes through the sampling circuit, collected weak current signals are converted into voltage signals (namely, the coupling point voltage and a first comparison voltage), and the first-stage operational amplifier circuit compares the converted voltage signals and performs amplification. When the first-stage operational amplifier circuit outputs a high voltage, the second-stage operational amplifier circuit outputs a low voltage. In this case, it may be determined that the antenna is in position. When the first-stage operational amplifier circuit outputs a low voltage, the second-stage operational amplifier circuit outputs a high voltage. In this case, it may be determined that the antenna is out of position. In this way, two-stage comparison and amplification is performed on the detected coupling point voltage of the antenna, to determine, based on a comparison result, whether the antenna is in position. This ensures accuracy of antenna detection.

In a possible implementation of the first aspect, the sampling circuit is configured to: sample the coupling point voltage of the antenna, and generate a first comparison voltage based on the power supply voltage. The first-stage operational amplifier circuit is configured to: compare the coupling point voltage with the first comparison voltage, and perform amplification, to output a first amplified voltage. The second-stage operational amplifier circuit is configured to: generate a second comparison voltage based on the power supply voltage, compare the first amplified voltage with the second comparison voltage, and perform amplification, to output the first indication signal. In the foregoing possible implementation, the in-position detection circuit adopts a design of a two-stage operational amplifier circuit, to implement a current hysteresis comparison function. In other words, current hysteresis comparison is implemented for the in-position detection current. In this way, the in-position detection current has a hysteresis range. The hysteresis range can raise a criterion for switching the in-position status of the antenna, so that a determining result is more accurate, and safety is higher. For example, the hysteresis range may be 4 mA to 10 mA. When the in-position detection current increases from a smaller value to 10 mA (> 10 mA), the in-position detection circuit determines that the antenna switches from an out-of-position state to an in-position state. When the in-position detection current decreases from a larger value to 4 mA (< 4 mA), the in-position detection circuit determines that the antenna switches from the in-position state to the out-of-position state.

In a possible implementation of the first aspect, the sampling circuit includes a first resistor and a second resistor, one end of the first resistor and one end of the second resistor are coupled and used as the first end of the sampling circuit, the other end of the first resistor is used as the second end of the sampling circuit, and the other end of the second resistor is used as the third end of the sampling circuit.

In a possible implementation of the first aspect, the first-stage operational amplifier circuit includes a first operational amplifier and a switch amplifier circuit. A first input end and a second input end of the first operational amplifier are respectively used as the first input end and the second input end of the first-stage operational amplifier circuit, an output end of the first operational amplifier is coupled to a control end of the switch amplifier circuit, the second input end of the first operational amplifier is coupled to an input end of the switch amplifier circuit, a power supply end of the first operational amplifier is configured to receive the power supply voltage, and an output end of the switch amplifier circuit is used as the output end of the first-stage operational amplifier circuit. In the foregoing possible implementation, when the first-stage operational amplifier circuit outputs a high voltage, a transistor in the switch amplifier circuit is conducted; and when the first-stage operational amplifier circuit outputs a low voltage, the transistor in the switch amplifier circuit is cut off, so that the first-stage operational amplifier circuit can compare the coupling point voltage with the first comparison voltage and perform amplification.

In a possible implementation of the first aspect, the switch amplifier circuit includes a first transistor, a third resistor, a fourth resistor, and a fifth resistor. A control terminal of the first transistor is coupled to the control end of the switch amplifier circuit through the third resistor, the control end of the first transistor is coupled to a ground end through the fourth resistor, a first terminal of the first transistor is coupled to the ground end through the fifth resistor, and a second terminal of the first transistor is coupled to the input end of the switch amplifier circuit. In the foregoing possible implementation, a simple and effective switch amplifier circuit is provided.

In a possible implementation of the first aspect, the second-stage operational amplifier circuit includes a first voltage division circuit and an operational amplifier circuit. An input end of the first voltage division circuit is used as the first input end of the second-stage operational amplifier circuit, an output end of the first voltage division circuit is coupled to a first input end of the operational amplifier circuit, a second input end of the operational amplifier circuit is used as the second input end of the second-stage operational amplifier circuit, and an output end of the operational amplifier circuit is used as the output end of the second-stage operational amplifier circuit. In the foregoing possible implementation, the first voltage division circuit may be configured to generate the second comparison voltage based on the power supply voltage. The operational amplifier circuit may compare the second comparison voltage with the first amplified voltage output by the first-stage operational amplifier, to output the first indication information, and indicate, by using the first indication information, whether the antenna is in position.

In a possible implementation of the first aspect, the first voltage division circuit includes a sixth resistor, a seventh resistor, and an eighth resistor. One end of the sixth resistor is used as the input end of the first voltage division circuit, the other end of the sixth resistor is coupled to one end of the seventh resistor and one end of the eighth resistor, the other end of the seventh resistor is coupled to the ground end, and the other end of the eighth resistor is used as the output end of the first voltage division circuit.

In a possible implementation of the first aspect, the operational amplifier circuit includes a second operational amplifier, a ninth resistor, and a tenth resistor. A first input end and a second input end of the second operational amplifier are respectively used as the first input end and the second input end of the operational amplifier circuit, one end of the ninth resistor is coupled to the first input end of the second operational amplifier, an output end of the second operational amplifier is coupled to the other end of the ninth resistor and one end of the tenth resistor, the other end of the tenth resistor is used as the output end of the operational amplifier circuit, and a power supply end of the second operational amplifier is configured to receive the power supply voltage. In the foregoing possible implementation, the second operational amplifier may compare the second comparison voltage with the first amplified voltage, to output the first indication information, and indicate, by using the first indication information, whether the antenna is in position.

In a possible implementation of the first aspect, the antenna detection circuit further includes an overcurrent detection circuit, an input end of the overcurrent detection circuit is configured to be coupled to the antenna, and a power supply end of the overcurrent detection circuit is configured to receive the power supply voltage. The switch circuit is further configured to turn on or turn off the power supply voltage for supplying power to the overcurrent detection circuit. The overcurrent detection circuit is configured to: receive the power supply voltage, detect the coupling point voltage of the antenna, generate a threshold voltage based on the power supply voltage, and compare the coupling point voltage with the threshold voltage, to output a second indication signal, where the second indication signal indicates whether the antenna is in an overcurrent state. In the foregoing possible implementation, the overcurrent detection circuit may compare the coupling point voltage of the antenna with the threshold voltage, to determine whether an overcurrent occurs in the antenna. This ensures accuracy of antenna detection, improves safety and reliability of the device, and avoids a user safety risk caused by a short circuit.

In a possible implementation of the first aspect, the overcurrent detection circuit includes a third operational amplifier, a second voltage division circuit, a current-limiting resistor, and a first capacitor. Both an input end of the second voltage division circuit and a power supply end of the third operational amplifier are configured to receive the power supply voltage, an output end of the second voltage division circuit is coupled to a first input end of the third operational amplifier, a second input end of the third operational amplifier is configured to be coupled to the antenna and coupled to the ground end through the first capacitor, and an output end of the third operational amplifier is coupled to an output end of the overcurrent detection circuit through the current-limiting resistor. In the foregoing possible implementation, a simple and effective overcurrent detection circuit is provided. The second voltage division circuit may be configured to generate the threshold voltage, and the third operational amplifier may be configured to compare the coupling point voltage of the antenna with the threshold voltage, to output the second indication signal.

In a possible implementation of the first aspect, the antenna detection circuit further includes a short-circuit detection circuit, and an input end of the short-circuit detection circuit is configured to be coupled to the antenna. The short-circuit detection circuit is configured to: detect the coupling point voltage of the antenna, and perform voltage division and sampling processing on the coupling point voltage, to output a third indication signal, where the third indication signal indicates whether the antenna is in a short-circuited state. In the foregoing possible implementation, the short-circuit detection circuit may detect whether the coupling point voltage of the antenna is 0, to determine whether the antenna is short-circuited. This ensures accuracy of antenna detection, improves safety and reliability of the device, and avoids a user safety risk caused by a short circuit.

In a possible implementation of the first aspect, the short-circuit detection circuit includes a third voltage division circuit, a sampling resistor, and a second capacitor. An input end of the third voltage division circuit is configured to be coupled to the antenna, an output end of the third voltage division circuit is coupled to one end of the sampling resistor and one end of the second capacitor, the other end of the sampling resistor is used as an output end of the short-circuit detection circuit, and the other end of the second capacitor is coupled to the ground end. In the foregoing possible implementation, a simple and effective short-circuit detection circuit is provided.

In a possible implementation of the first aspect, the controller is further configured to: receive an indication signal, and control, based on the indication information, the switch circuit to be turned on or turned off, where the indication signal includes at least one of the first indication signal, the second indication signal, or the third indication signal. In the foregoing possible implementation, the controller may receive the first indication signal that indicates whether the antenna is in position, the second indication signal that indicates whether an overcurrent occurs in the antenna, and the third indication signal that indicates whether the antenna is short-circuited, so that the controller can control, based on the received indication signal, the switch circuit to be turned on or turned off. For example, the switch circuit is turned off when a short circuit or an overcurrent occurs in the antenna. This improves safety and reliability of the antenna and a terminal device in which the antenna detection circuit is used.

In a possible implementation of the first aspect, the switch circuit includes a second transistor, a third capacitor, and an RC circuit. The third capacitor is coupled between a control terminal and a first terminal of the second transistor, the RC circuit is coupled between the control terminal and a second terminal of the second transistor, the first terminal of the second transistor is further configured to output the power supply voltage, the second terminal of the second transistor is further configured to receive the power supply voltage, and the control end of the second transistor is further configured to receive a control signal. In the foregoing possible implementation, a simple and effective switch circuit is provided.

According to a second aspect, an antenna detection method is provided, and is applied to an antenna detection circuit. The antenna detection circuit includes a controller, a switch circuit, and an in-position detection circuit, the in-position detection circuit is configured to be coupled to an antenna, and the method includes: The controller controls the switch circuit to be turned on or turned off; the switch circuit turns on or turns off a power supply voltage for supplying power to the in-position detection circuit; and the in-position detection circuit receives the power supply voltage, detects a coupling point voltage of the antenna, and performs two-stage comparison and amplification on the coupling point voltage based on the power supply voltage, to output a first indication signal, where the first indication signal indicates whether the antenna is in position.

In a possible implementation of the second aspect, the in-position detection circuit includes a sampling circuit, a first-stage operational amplifier circuit, and a second-stage operational amplifier circuit. The sampling circuit samples the coupling point voltage of the antenna, and generates a first comparison voltage based on the power supply voltage. The first-stage operational amplifier circuit compares the coupling point voltage with the first comparison voltage, and performs amplification, to output a first amplified voltage. The second-stage operational amplifier circuit generates a second comparison voltage based on the power supply voltage, compares the first amplified voltage with the second comparison voltage, and performs amplification, to output the first indication signal.

In a possible implementation of the second aspect, the antenna detection circuit further includes an overcurrent detection circuit, the overcurrent detection circuit is configured to be coupled to the antenna, and the method further includes: The switch circuit turns on or turns off the power supply voltage for supplying power to the overcurrent detection circuit; and the overcurrent detection circuit receives the power supply voltage, detects the coupling point voltage of the antenna, generates a threshold voltage based on the power supply voltage, and compares the coupling point voltage with the threshold voltage, to output a second indication signal, where the second indication signal indicates whether the antenna is in an overcurrent state.

In a possible implementation of the second aspect, the antenna detection circuit further includes a short-circuit detection circuit, the short-circuit detection circuit is configured to be coupled to the antenna, and the method further includes: The short-circuit detection circuit detects the coupling point voltage of the antenna, and performs voltage division and sampling processing on the coupling point voltage, to output a third indication signal, where the third indication signal indicates whether the antenna is in a short-circuited state.

In a possible implementation of the second aspect, that the controller controls the switch circuit to be turned on or turned off includes: The controller receives an indication signal, and controls, based on the indication information, the switch circuit to be turned on or turned off, where the indication signal includes at least one of the first indication signal, the second indication signal, or the third indication signal.

According to another aspect of this application, an in-vehicle device is provided. The in-vehicle device includes a power supply and an antenna detection circuit. The power supply is configured to provide a power supply voltage for the antenna detection circuit. The antenna detection circuit is the antenna detection circuit provided in the first aspect or any one of the possible implementations of the first aspect.

According to still another aspect of this application, a vehicle is provided. The vehicle includes the in-vehicle device provided in any one of the foregoing aspects or any possible implementation of any one of the foregoing aspects.

It may be understood that, for beneficial effect that can be achieved by any antenna detection method, in-vehicle device, and vehicle provided above, refer to the beneficial effect of the antenna detection circuit provided above. Details are not described herein again.

### BRIEF DESCRIPTION OF DRAWINGS

FIG. 1 is a diagram of a structure of a terminal device according to an embodiment of this application;
FIG. 2 is a diagram of a structure of an antenna detection circuit according to an embodiment of this application;
FIG. 3 is a diagram of a structure of another antenna detection circuit according to an embodiment of this application;
FIG. 4 is a diagram of a structure of still another antenna detection circuit according to an embodiment of this application;
FIG. 5 is a diagram of a structure of an overcurrent detection circuit according to an embodiment of this application;
FIG. 6 is a diagram of a structure of a short-circuit detection circuit according to an embodiment of this application;
FIG. 7 is a diagram of a structure of another terminal device according to an embodiment of this application; and
FIG. 8 is a schematic flowchart of an antenna detection method according to an embodiment of this application.

### DESCRIPTION OF EMBODIMENTS

The making and use of embodiments are discussed in detail below. It should be appreciated, however, that many applicable inventive concepts provided in this application may be implemented in a plurality of specific environments. The specific embodiments discussed are merely illustrative of specific ways to implement and use this description and this technology, and do not limit the scope of this application.

Unless otherwise defined, all technical terms used herein have the same meaning as those commonly known to a person of ordinary skill in the art.

The circuits or other components may be described as or referred to as "configured to" perform one or more tasks. In this case, the term "configured to" is used to imply a structure by indicating that a circuit/component includes a structure (for example, a circuit system) that performs one or more tasks during operation. Therefore, even when a specified circuit/component is currently not operable (for example, not opened), the circuit/component may also be referred to as being configured to perform the task. Circuits/components used in conjunction with the "configured to" phrase include hardware, for example, a circuit for performing an operation.

The following describes the technical solutions in embodiments of this application with reference to the accompanying drawings in embodiments of this application. In this application, "at least one" means one or more, and "a plurality of" means two or more. The term "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one of a, b, or c may represent: a, b, c, a and b, a and c, b and c, or a, b, and c, where a, b, and c may be singular or plural.

In embodiments of this application, words such as "first" and "second" are used to distinguish between objects with similar names, functions or effects. A person skilled in the art may understand that the words such as "first" and "second" do not limit a quantity and an execution sequence. The term "coupling" is used to represent an electrical connection, including a direct connection through a wire or a connection end or an indirect connection through another component. Therefore, "coupling" should be considered as a generalized electronic communication connection.

In this application, the terms such as "example" or "for example" are used to represent giving an example, an illustration, or descriptions. Any embodiment or design solution described as an "example" or "for example" in this application should not be explained as being more preferred or having more advantages than another embodiment or design solution. To be precise, use of the word such as "example" or "for example" is intended to present a related concept in a specific manner.

Self-driving vehicles (self-driving cars), also referred to as autonomous driving vehicles, computer-driven vehicles, or wheeled mobile robots, are intelligent vehicles that implement self-driving through computer systems. Implementation of autonomous driving technologies depends on continuous development of two types of technologies: perception and decision-making. One of the cores of the perception technologies is a vehicle positioning technology. The vehicle positioning technology provides real-time positioning information for vehicles by leveraging all-weather, global coverage, and other features of a global navigation satellite system (global navigation satellite system, GNSS).

Implementation of the foregoing vehicle positioning function depends on normal operation of an antenna. Therefore, there is a need to perform detection for an abnormality of the antenna, for example, perform detection on an in-position status, a short-circuit status, and an overcurrent status of the antenna. An existing antenna detection circuit usually can only detect the in-position status of the antenna. Specifically, an in-position detection signal of the antenna is compared with a specific single threshold, to determine the in-position status of the antenna. However, this method may result in an incorrect determination, leading to low accuracy.

Based on this, an embodiment of this application provides an antenna detection circuit that may be configured to detect an in-position status of an antenna, and during detection of the in-position status of the antenna, the in-position status of the antenna can be determined by comparing, based on a change of a signal parameter of the antenna, the signal parameter and different thresholds, to reduce a probability of an incorrect determination and improve accuracy. In addition, the antenna detection circuit may be further configured to detect a short-circuit status and an overcurrent status of the antenna, and control power supply statuses of the antenna and the antenna detection circuit based on detection results, to protect the antenna, the antenna detection circuit, a device in which the circuit is used, and the like. This improves product safety and reliability.

The technical solutions provided in embodiments of this application may be applied to various terminal devices having the antenna detection circuit. The terminal device may include but is not limited to a mobile phone, a tablet computer, a computer, a notebook computer, an ultra-mobile personal computer (ultra-mobile personal computer, umPC), a netbook, a video camera, a camera, a wearable device, a vehicle (for example, a car, a bicycle, an electric vehicle, an airplane, a ship, a train, or a high-speed railway), an in-vehicle device, a virtual reality (virtual reality, VR) device, an augmented reality (augmented reality, AR) device, or an intelligent robot. For ease of description, the following uses the vehicle as an example to describe a structure of the terminal device.

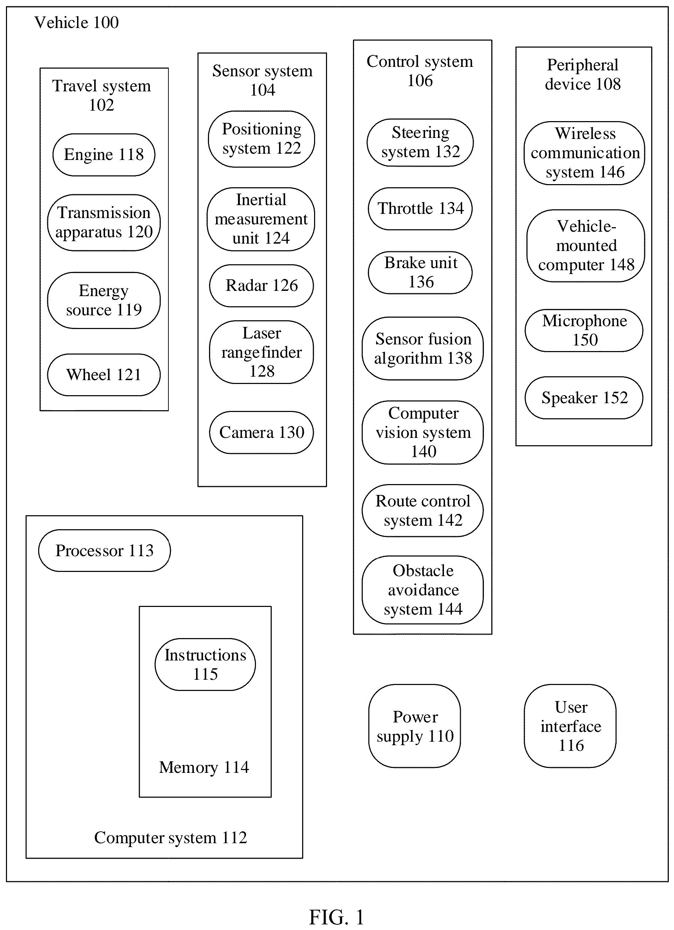

FIG. 1 is a diagram of a structure of a vehicle 100 having an autonomous driving function according to an embodiment of this application. In an embodiment, the vehicle 100 is configured to be in a fully or partially autonomous driving mode. For example, the vehicle 100 in the autonomous driving mode may control the vehicle 100. A manual operation may be performed to determine current states of the vehicle and an ambient environment of the vehicle, determine possible behavior of at least one another vehicle in the ambient environment, determine confidence corresponding to a possibility that the another vehicle performs the possible behavior, and control the vehicle 100 based on determined information. When the vehicle 100 is in the autonomous driving mode, the vehicle 100 may be set to operate without interacting with a person.

The vehicle 100 may include various subsystems, for example, a travel system 102, a sensor system 104, a control system 106, one or more peripheral devices 108, a power supply 110, a computer system 112, and a user interface 116. Optionally, the vehicle 100 may include more or fewer subsystems, and each subsystem may include a plurality of elements. In addition, each subsystem and element of the vehicle 100 may be interconnected in a wired or wireless manner.

The travel system 102 may include a component that provides power for the vehicle 100 to move. In an embodiment, the travel system 102 may include an engine 118, an energy source 119, a transmission apparatus 120, and a wheel/tire 121. The engine 118 may be a combination of an internal combustion engine, an electric motor, an air compression engine, or another type of engine, for example, a hybrid engine including a gasoline engine and an electric motor, or a hybrid engine including an internal combustion engine and an air compression engine. The engine 118 converts the energy source 119 into mechanical energy.

Examples of the energy source 119 include gasoline, diesel, other oil-based fuels, propane, other compressed gas-based fuels, ethanol, solar panels, batteries, and other power sources. The energy source 119 may also provide energy for another system of the vehicle 100.

The transmission apparatus 120 may transmit mechanical power from the engine 118 to the wheel 121. The transmission apparatus 120 may include a gearbox, a differential, and a drive shaft. In an embodiment, the transmission apparatus 120 may further include another component, for example, a clutch. The drive shaft may include one or more shafts that may be coupled to one or more of the wheels 121.

The sensor system 104 may include several sensors that can sense information about the ambient environment of the vehicle 100. For example, the sensor system 104 may include a positioning system 122 (the positioning system may be a global positioning system (global positioning system, GPS), or may be a BeiDou system or another positioning system), an inertial measurement unit (inertial measurement unit, IMU) 124, radar 126, a laser rangefinder 128, and a camera 130. The sensor system 104 may further include a sensor (for example, an in-vehicle air quality monitor, a fuel gauge, or an engine oil thermometer) of an internal system of the monitored vehicle 100. Sensor data from one or more of these sensors can be used to detect an object and corresponding features (a position, a shape, a direction, a speed, and the like) of the object. Such detection and identification are key functions of a safe operation of the autonomous vehicle 100.

The positioning system 122 may be configured to estimate a geographical position of the vehicle 100. The IMU 124 is configured to sense a location change and an orientation change of the vehicle 100 based on inertial acceleration. In an embodiment, the IMU 124 may be a combination of an accelerometer and a gyroscope.

The radar 126 may sense an object in the ambient environment of the vehicle 100 by using a radio signal. In some embodiments, in addition to sensing an object, the radar 126 may be further configured to sense a speed and/or a moving direction of the object.

The laser rangefinder 128 may sense, by using a laser, an object in an environment in which the vehicle 100 is located. In some embodiments, the laser rangefinder 128 may include one or more laser sources, a laser scanner, one or more detectors, and another system component.

The camera 130 may be configured to capture a plurality of images of the ambient environment of the vehicle 100. The camera 130 may be a static camera or a video camera.

The control system 106 controls operations of the vehicle 100 and components of the vehicle 100. The control system 106 may include various elements, including a steering system 132, a throttle 134, a brake unit 136, a sensor fusion algorithm 138, a computer vision system 140, a route control system 142, and an obstacle avoidance system 144.

The steering system 132 may be operated to adjust a moving direction of the vehicle 100. For example, in an embodiment, the steering system 132 may be a steering wheel system.

The throttle 134 is configured to control an operating speed of the engine 118 and further control a speed of the vehicle 100.

The brake unit 136 is configured to control the vehicle 100 to decelerate. The brake unit 136 may use friction to slow down the wheel 121. In another embodiment, the brake unit 136 may convert kinetic energy of the wheel 121 into a current. The brake unit 136 may alternatively use another form to reduce a rotational speed of the wheel 121, to control the speed of the vehicle 100.

The computer vision system 140 may operate to process and analyze an image captured by the camera 130, to identify an object and/or a feature in the ambient environment of the vehicle 100. The object and/or the feature may include a traffic signal, a road boundary, and an obstacle. The computer vision system 140 may use an object identification algorithm, a structure from motion (structure from motion, SFM) algorithm, video tracking, and another computer vision technology. In some embodiments, the computer vision system 140 may be configured to: draw a map for an environment, track an object, estimate a speed of the object, and the like.

The route control system 142 is configured to determine a traveling route of the vehicle 100. In some embodiments, the route control system 142 may determine the traveling route of the vehicle 100 with reference to data from the sensor 138, the GPS 122, and one or more predetermined maps.

The obstacle avoidance system 144 is configured to identify, evaluate, and avoid or bypass, in another manner, a potential obstacle in the environment of the vehicle 100.

Certainly, in an instance, the control system 106 may additionally or alternatively include a component other than those shown and described. Alternatively, the control system 106 may delete some of the components shown above.

The vehicle 100 interacts with an external sensor, another vehicle, another computer system, or a user by using the peripheral device 108. The peripheral device 108 may include a wireless communication system 146, a vehicle-mounted computer 148, a microphone 150, and/or a speaker 152.

In some embodiments, the peripheral device 108 provides a means for the user of the vehicle 100 to interact with the user interface 116. For example, the vehicle-mounted computer 148 may provide information for the user of the vehicle 100. The user interface 116 may further operate the vehicle-mounted computer 148 to receive a user input. The vehicle-mounted computer 148 may perform an operation through a touchscreen. In another case, the peripheral device 108 may provide a means for the vehicle 100 to communicate with another device located in the vehicle. For example, the microphone 150 may receive audio (for example, a voice command or another audio input) from the user of the vehicle 100. Similarly, the speaker 152 may output audio to the user of the vehicle 100.

The wireless communication system 146 may wirelessly communicate with one or more devices directly or through a communication network. For example, the wireless communication system 146 may use 3G cellular communication such as code division multiple access (code division multiple access, CDMA), EVD0, a global system for mobile communications (global system for mobile communications, GSM), or a general packet radio service (general packet radio service, GPRS); 4G cellular communication such as long term evolution (long term evolution, LTE); or 5G cellular communication. The wireless communication system 146 may communicate with a wireless local area network (wireless local area network, WLAN) through Wi-Fi. In some embodiments, the wireless communication system 146 may communicate directly with a device through an infrared link or by using Bluetooth or ZigBee (ZigBee). Other wireless protocols, for example, various vehicle communication systems such as the wireless communication system 146, may include one or more dedicated short range communication (dedicated short range communication DSRC) devices, which may include public and/or private data communication between vehicles and/or roadside stations.

The power supply 110 may provide power for various components of the vehicle 100. In an embodiment, the power supply 110 may be a rechargeable lithium-ion or lead-acid battery. One or more battery packs of such a battery may be configured as a power supply to supply power to the various components of the vehicle 100. In some embodiments, the power supply 110 and the energy source 119 may be implemented together, for example, in some all-electric vehicles.

Some or all of functions of the vehicle 100 are controlled by the computer system 112. The computer system 112 may include at least one processor 113, and the processor 113 executes instructions 115 stored in a non-transient computer-readable medium such as the memory 114. The computer system 112 may alternatively be a plurality of computing devices that control an individual component or a subsystem of the vehicle 100 in a distributed manner.

The processor 113 may be any conventional processor, such as a commercially available central processing unit (central processing unit, CPU). Optionally, the processor may be a dedicated device, for example, an application-specific integrated circuit (application-specific integrated circuit, ASIC) or another hardware-based processor. Although FIG. 1 functionally shows the processor, the memory, and other elements of the computer in a same block, a person of ordinary skill in the art should understand that the processor, the computer, or the memory may actually include a plurality of processors, computers, or memories that may or may not be stored in a same physical housing. For example, the memory may be a hard disk drive or another storage medium located in a housing different from that of the computer. Thus, it is understood that a reference to the processor or the computer includes a reference to a set of processors, computers, or memories that may or may not operate in parallel. Different from using a single processor to perform the steps described herein, some components such as a steering component and a deceleration component may include respective processors. The processor performs only computation related to a component-specific function.

In various aspects described herein, the processor may be located far away from the vehicle and wirelessly communicate with the vehicle. In another aspect, some processes described herein are performed on a processor disposed inside the vehicle, while others are performed by a remote processor, including performing steps necessary for single manipulation.

In some embodiments, the memory 114 may include the instructions 115 (for example, program logic), and the instructions 115 may be executed by the processor 113 to perform various functions of the vehicle 100, including the functions described above. The memory 114 may also include additional instructions, including instructions used to send data to, receive data from, interact with, and/or control one or more of the travel system 102, the sensor system 104, the control system 106, and the peripheral device 108.

In addition to the instructions 115, the memory 114 may further store data, such as a road map, route information, vehicle data of the vehicle such as a location, a direction, and a speed, and other information. Such information may be used by the vehicle 100 and the computer system 112 during operation of the vehicle 100 in autonomous, semi-autonomous, and/or manual modes.

The user interface 116 is configured to provide information for or receive information from the user of the vehicle 100. Optionally, the user interface 116 may include one or more input/output devices in a set of peripheral devices 108, for example, the wireless communication system 146, the vehicle-mounted computer 148, the microphone 150, and the speaker 152.

The computer system 112 may control a function of the vehicle 100 based on inputs received from various subsystems (for example, the travel system 102, the sensor system 104, and the control system 106) and from the user interface 116. For example, the computer system 112 may use the input from the control system 106 to control the steering system 132 to avoid an obstacle detected by the sensor system 104 and the obstacle avoidance system 144. In some embodiments, the computer system 112 may operate to provide control on the vehicle 100 and the subsystems of the vehicle 100 in many aspects.

Optionally, one or more of the foregoing components may be installed separately from or associated with the vehicle 100. For example, the memory 114 may be partially or completely separated from the vehicle 100. The foregoing components may be communicatively coupled together in a wired and/or wireless manner.

Optionally, the foregoing components are merely examples. During actual application, components in the foregoing modules may be added or deleted according to an actual requirement. FIG. 1 should not be understood as a limitation on embodiments of this application.

An autonomous driving vehicle traveling on a road, for example, the vehicle 100 above, may identify an object in a surrounding environment of the vehicle, to determine adjustment on a current speed. The object may be another vehicle, a traffic control device, or another type of object. In some examples, each identified object may be considered independently, and may be used to determine a speed to be adjusted to by the autonomous driving vehicle based on features of each object, such as a current speed of the object, acceleration of the object, and a distance between the object and the vehicle.

Optionally, the autonomous driving vehicle 100 or a computing device (for example, the computer system 112, the computer vision system 140, or the memory 114 in FIG. 1) associated with the autonomous driving vehicle 100 may predict behavior of the identified object based on features of the identified object and a status (for example, traffic, rain, or ice on a road) of the ambient environment. Optionally, all identified objects depend on behavior of each other, and therefore all the identified objects may be considered together to predict behavior of a single identified object. The vehicle 100 can adjust the speed of the vehicle 100 based on the predicted behavior of the identified object. In other words, the autonomous driving vehicle can determine, based on the predicted behavior of the object, a specific stable state (for example, acceleration, deceleration, or stop) to which the vehicle needs to be adjusted. In this process, another factor may be further considered to determine a speed of the vehicle 100, for example, a lateral position of the vehicle 100 on the road on which the vehicle travels, a curvature of the road, and proximity between a static object and a dynamic object.

In addition to providing instructions for adjusting the speed of the autonomous driving vehicle, the computing device may further provide instructions for modifying a steering angle of the vehicle 100, so that the autonomous driving vehicle can follow a given track and/or maintain safe horizontal and vertical distances from an object (for example, a car in a neighboring lane on the road) near the autonomous driving vehicle.

The vehicle 100 may include a transportation means on a road, a transportation means on water, a transportation means in air, an industrial device, an agricultural device, an entertainment device, or the like. The vehicle may be a vehicle in a broad sense. For example, the vehicle may be a transportation means (for example, a commercial vehicle, a passenger vehicle, a motorcycle, a flight vehicle, or a train), an industrial vehicle (for example, a forklift, a trailer, or a tractor), an engineering vehicle (for example, an excavator, a bulldozer, or a crane), an agricultural device (for example, a lawn mower or a harvester), a recreation device, a toy vehicle, or the like.

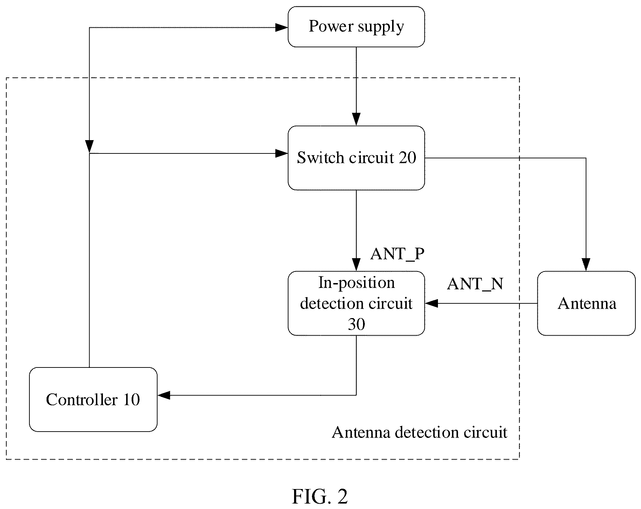

FIG. 2 is a diagram of a structure of an antenna detection circuit according to an embodiment of this application. The antenna detection circuit may be used in the terminal device provided above. For example, the antenna detection circuit may be used in a vehicle to support the vehicle in implementing a vehicle positioning function.

The antenna detection circuit includes a controller 10, a switch circuit 20, and an in-position detection circuit 30. An output end of the controller 10 is coupled to a control end of the switch circuit 20, an input end of the switch circuit 20 is configured to be coupled to a power supply, an output end of the switch circuit 20 is coupled to a first input end of the in-position detection circuit 30, a second input end of the in-position detection circuit 30 is configured to be coupled to an antenna, and a node coupled to the antenna may also be referred to as a coupling point of the antenna. In FIG. 2, the first input end and the second input end of the in-position detection circuit 30 are respectively represented as ANT_P and ANT_N.

The controller 10 is configured to control the switch circuit 20 to be turned on or turned off. For example, the controller 10 may be configured to output a control signal, and the control signal may be used to control the switch circuit 20 to be turned on or turned off. For example, when the control signal is at a high level, the control signal may be used to control the switch circuit 20 to be turned on; or when the control signal is at a low level, the control signal may be used to control the switch circuit 20 to be turned off. Optionally, the controller 10 may be a microcontroller unit (micro controller unit, MCU), or may be another component having a control function in the terminal device. The power supply may be further configured to supply power to the controller 10.

The switch circuit 20 is configured to turn on or turn off a power supply voltage for supplying power to the in-position detection circuit 30, where the power supply voltage may be provided by the power supply. That the switch circuit 20 turns on the power supply voltage for supplying power to the in-position detection circuit 30 may also be referred to as that the switch circuit 20 connects the in-position detection circuit 30 to the power supply. In other words, when the switch circuit 20 is in a turned-on state, the power supply voltage may supply power to the in-position detection circuit 30 after passing through the switch circuit 20. Similarly, that the switch circuit 20 turns off the power supply voltage for supplying power to the in-position detection circuit 30 may also be referred to as that the switch circuit 20 disconnects the in-position detection circuit 30 from the power supply. In other words, when the switch circuit 20 is in a turned-off state, the power supply voltage is turned off, thereby no longer supplying power to the in-position detection circuit 30. Optionally, the switch circuit 20 may be further configured to turn on or turn off power supply to the antenna.

The in-position detection circuit 30 is configured to receive the power supply voltage, detect a coupling point voltage of the antenna, and perform two-stage comparison and amplification on the coupling point voltage based on the power supply voltage, to output a first indication signal, where the first indication signal indicates whether the antenna is in position. Performing two-stage comparison and amplification on the coupling point voltage may be: comparing coupling point voltages in different antenna states with different thresholds through two-stage comparison and amplification. In addition, the in-position status of the antenna includes two states: an in-position state and an out-of-position state. That the antenna is in position may mean that the antenna is normally connected, and that the antenna is out of position may mean that the antenna is abnormally connected or disconnected. The first indication signal indicates whether the antenna is in position. For example, when the first indication signal is at a low level, the first indication signal may indicate that the antenna is in position; or when the first indication signal is at a high level, the first indication signal may indicate that the antenna is out of position.

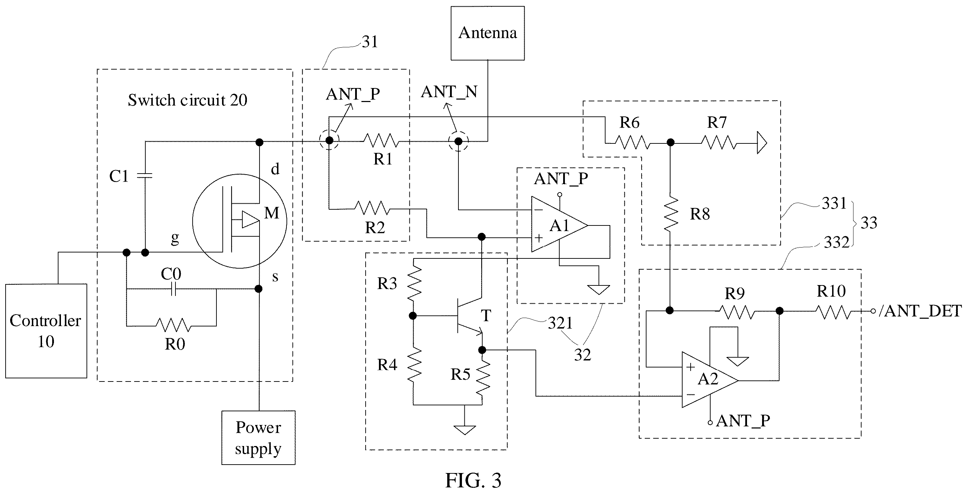

In a possible embodiment, as shown in FIG. 3, the switch circuit 20 may include a transistor M, a capacitor C, and an RC circuit. The capacitor is coupled between a control terminal and a first terminal of the transistor M, the RC circuit is coupled between the control terminal and a second terminal of the transistor M, the first terminal of the transistor M is further configured to output the power supply voltage, the second terminal of the transistor M is further configured to receive the power supply voltage, and the control end of the transistor M is further configured to receive the control signal.

Optionally, the transistor M may be a metal-oxide-semiconductor (metal-oxide-semiconductor, MOS) transistor, and the transistor is classified into two types: an N (negative, negative)-type transistor and a P (positive, positive)-type transistor. The transistor M includes a source (source, s), a drain (drain, d), and a gate (gate, g), and the transistor M may be controlled, through control of a level input to the gate of the transistor M, to be conducted or cut off. The gate of the transistor M may also be referred to as the control terminal, the source is referred to as the first terminal, and the drain is referred to as the second terminal; or the gate is referred to as the control terminal, the drain is referred to as the first terminal, and the source is referred to as the second terminal.

Further, as shown in FIG. 3, the in-position detection circuit 30 may include a sampling circuit 31, a first-stage operational amplifier circuit 32, and a second-stage operational amplifier circuit 33. A first end of the sampling circuit 31 and a first input end of the second-stage operational amplifier circuit 33 are coupled and used as the first input end of the in-position detection circuit 30, a second end and a third end of the sampling circuit 31 are respectively coupled to a first input end and a second input end of the first-stage operational amplifier circuit 32, an output end of the first-stage operational amplifier circuit 32 is coupled to a second input end of the second-stage operational amplifier circuit 33, an output end of the second-stage operational amplifier circuit 33 is used as an output end of the in-position detection circuit 30, and the second end of the sampling circuit 31 is further configured to be coupled to the antenna.

In the in-position detection circuit 30, the sampling circuit 31 may be configured to sample the coupling point voltage of the antenna, and generate a first comparison voltage based on the power supply voltage. The first-stage operational amplifier circuit 32 may be configured to compare the coupling point voltage with the first comparison voltage, and perform amplification, to output a first amplified voltage. The second-stage operational amplifier circuit 33 is configured to generate a second comparison voltage based on the power supply voltage, compare the first amplified voltage with the second comparison voltage, and perform amplification, to output the first indication signal. In FIG. 3, the first indication signal is represented as /ANT_DET.

In a possible embodiment, as shown in FIG. 3, the sampling circuit may include a first resistor R1 and a second resistor R2, one end of the first resistor and one end of the second resistor are coupled and used as the first end of the sampling circuit 31, the other end of the first resistor R1 is used as the second end of the sampling circuit, and the other end of the second resistor R2 is used as the third end of the sampling circuit. The first end of the sampling circuit 31 may be configured to receive the power supply voltage, the second end of the sampling circuit is configured to sample the coupling point voltage of the antenna, and the third end of the sampling circuit 31 may be configured to output the first comparison voltage.

In a possible embodiment, as shown in FIG. 3, the first-stage operational amplifier circuit 32 may include a first operational amplifier A1 and a switch amplifier circuit 321. A first input end and a second input end of the first operational amplifier A1 are respectively used as the first input end and the second input end of the first-stage operational amplifier circuit 32, an output end of the first operational amplifier A1 is coupled to a control end of the switch amplifier circuit 321, the second input end of the first operational amplifier A1 is coupled to an input end of the switch amplifier circuit 321, a power supply end of the first operational amplifier A1 is configured to receive the power supply voltage, and an output end of the switch amplifier circuit 321 is used as the output end of the first-stage operational amplifier circuit 32. Optionally, the first input end of the first operational amplifier A1 may be an inverting input end, and the second input end of the first operational amplifier A1 may be a non-inverting input end.

The first input end of the first operational amplifier A1 may be configured to receive the coupling point voltage, the second input end of the first operational amplifier A1 may be configured to receive the first comparison voltage, the output end of the first operational amplifier A1 may be configured to output a first comparison result, and the first comparison result may be a high level or a low level. For example, when the first comparison voltage is greater than the coupling point voltage, the output end of the first operational amplifier A1 may be configured to output a high level; or when the first comparison voltage is less than the coupling point voltage, the output end of the first operational amplifier A1 may be configured to output a low level.

Optionally, as shown in FIG. 3, the switch amplifier circuit 321 may include a first transistor T, a third resistor R3, a fourth resistor R4, and a fifth resistor R5. A control terminal of the first transistor T is coupled to the control end of the switch amplifier circuit 321 through the third resistor R3. The control end of the first transistor T1 is coupled to a ground end GND through the fourth resistor R4. A first terminal of the first transistor T is coupled to the ground end through the fifth resistor R5, and a second terminal of the first transistor T is coupled to the input end of the switch amplifier circuit 321.

The first transistor T in this embodiment of this application may be a transistor, and a type of the transistor may be NPN or PNP. The control terminal (which may also be referred to as the control end) of the first transistor T may be a base of the transistor, the first terminal of the first transistor T may be one of an emitter or a collector, and the second terminal of the first transistor T may be the other of the emitter or the collector. In FIG. 3, an example in which the first terminal of the first transistor T is the emitter and the second terminal of the first transistor T is the collector is used for description.

In the switch amplifier circuit 321, the control end (namely, an end that is of the third resistor R3 and that is away from the first transistor T) of the switch amplifier circuit 321 may be configured to receive the first comparison result, the input end (namely, the second terminal of the first transistor T) of the switch amplifier circuit 321 may be configured to receive the first comparison voltage, and the output end (namely, the first terminal of the first transistor T) of the switch amplifier circuit 321 may be configured to output the first amplified voltage. Specifically, when the first comparison result output by the first operational amplifier A1 is the high level, the first transistor T is in a conducted state. In this case, the output end of the switch amplifier circuit 321 is configured to output a high level, where the high level may also be referred to as the first amplified voltage. When the first comparison result output by the first operational amplifier A1 is the low level, the first transistor T is in a cut-off state. In other words, the switch amplifier circuit 321 is in the turned-off state. In this case, the output end of the switch amplifier circuit 321 is configured to output a low level.

In a possible embodiment, as shown in FIG. 3, the second-stage operational amplifier circuit 33 includes a first voltage division circuit 331 and an operational amplifier circuit 332. An input end of the first voltage division circuit 331 is used as the first input end of the second-stage operational amplifier circuit 33. An output end of the first voltage division circuit 331 is coupled to a first input end of the operational amplifier circuit 332. A second input end of the operational amplifier circuit 332 is used as the second input end of the second-stage operational amplifier circuit 33. An output end of the operational amplifier circuit 332 is used as the output end of the second-stage operational amplifier circuit 33. The first voltage division circuit 331 may be configured to generate the second comparison voltage based on the power supply voltage, and the operational amplifier circuit 332 may be configured to compare the second comparison voltage with the first amplified voltage, to output the first indication signal.

Optionally, the first voltage division circuit 331 includes a sixth resistor R6, a seventh resistor R7, and an eighth resistor R8. One end of the sixth resistor R6 is used as the input end of the first voltage division circuit 331. The other end of the sixth resistor R6 is coupled to one end of the seventh resistor R7 and one end of the eighth resistor R8. The other end of the seventh resistor R7 is coupled to the ground end GND. The other end of the eighth resistor R8 is used as the output end of the first voltage division circuit 331.

Optionally, the operational amplifier circuit 332 includes a second operational amplifier A2, a ninth resistor R9, and a tenth resistor R10. A first input end and a second input end of the second operational amplifier A2 are respectively used as the first input end and the second input end of the operational amplifier circuit 332. One end of the ninth resistor R9 is coupled to the first input end of the second operational amplifier A2. An output end of the second operational amplifier A2 is coupled to the other end of the ninth resistor R9 and one end of the tenth resistor R10. The other end of the tenth resistor R10 is used as the output end of the operational amplifier circuit 332. A power supply end of the second operational amplifier A2 is configured to receive the power supply voltage. Optionally, the first input end of the second operational amplifier A2 may be a non-inverting input end, and the second input end of the first operational amplifier A1 may be an inverting input end.

The in-position detection circuit 30 adopts a design of a two-stage operational amplifier circuit, to implement a current hysteresis comparison function. In other words, current hysteresis comparison is implemented on an in-position detection current (for example, a current at the first input end ANT_P or the second input end ANT_N of the in-position detection circuit 30). In this way, the in-position detection current has a hysteresis range. The hysteresis range can raise a criterion for switching the in-position status of the antenna, so that a determining result is more accurate, and safety is higher. For example, the hysteresis range may be 4 mA to 10 mA. When the in-position detection current increases from a smaller value to 10 mA (> 10 mA), the in-position detection circuit 30 determines that the antenna switches from the out-of-position state to the in-position state. When the in-position detection current decreases from a larger value to 4 mA (< 4 mA), the in-position detection circuit 30 determines that the antenna switches from the in-position state to the out-of-position state.

In addition, a relationship between an output voltage Vout of the second operational amplifier A2 and the in-position detection current may be obtained through calculation based on virtual short and virtual open characteristics of the operational amplifier circuit, so that the hysteresis range can be determined based on the relationship between the output voltage Vout of the second operational amplifier A2 and the in-position detection current. During actual application, the hysteresis range may be set by adjusting resistance values of the resistors in the foregoing circuits (for example, resistance values of R1, R2, R5, R6, R7, R8, and R9).

In this embodiment of this application, after a current generated by the antenna passes through the first resistor R1 and the second resistor R2 in the sampling circuit 31, collected weak current signals are converted into voltage signals (namely, the coupling point voltage of the antenna and the first comparison voltage), and the first-stage operational amplifier circuit 32 compares the converted voltage signals and performs amplification. When the first operational amplifier A1 outputs a high voltage, the transistor in the switch amplifier circuit 321 is conducted, and the second-stage operational amplifier circuit 33 outputs a low voltage. In this case, it may be determined that the antenna is in position. When the first operational amplifier A1 outputs a low voltage, the transistor in the switch amplifier circuit 321 is cut off, and the second-stage operational amplifier circuit 33 outputs a high voltage. In this case, it may be determined that the antenna is out of position. In this way, two-stage comparison and amplification is performed on the detected coupling point voltage of the antenna, to determine, based on a comparison result, whether the antenna is in position. This ensures accuracy of antenna detection.

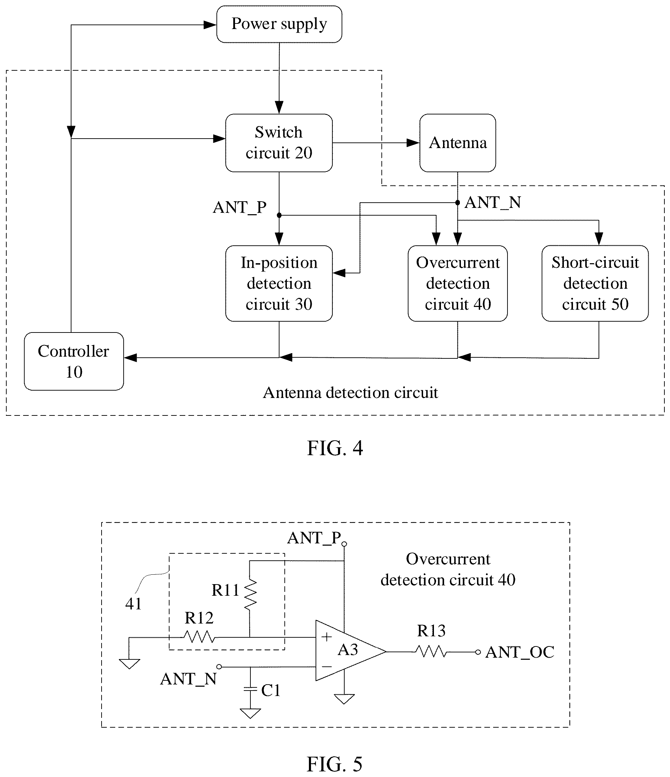

Further, as shown in FIG. 4, the antenna detection circuit may further include an overcurrent detection circuit 40, where an input end of the overcurrent detection circuit 40 is configured to be coupled to the antenna, and a power supply end of the overcurrent detection circuit 40 is configured to receive the power supply voltage.

The switch circuit 20 is further configured to turn on or turn off the power supply voltage for supplying power to the overcurrent detection circuit 40. The overcurrent detection circuit 40 is configured to: receive the power supply voltage, detect the coupling point voltage of the antenna, generate a threshold voltage based on the power supply voltage, and compare the coupling point voltage with the threshold voltage, to output a second indication signal, where the second indication signal indicates whether the antenna is in an overcurrent state. For example, when the threshold voltage is greater than the coupling point voltage and the second indication signal is at a high level, the second indication signal may indicate that the antenna is in the overcurrent state; or when the threshold voltage is less than the coupling point voltage and the second indication signal is at a low level, the second indication signal may indicate that the antenna is not in the overcurrent state.

In a possible embodiment, as shown in FIG. 5, the overcurrent detection circuit 40 may include a third operational amplifier A3, a second voltage division circuit 41, a current-limiting resistor R13, and a first capacitor C1. Both an input end of the second voltage division circuit 41 and a power supply end of the third operational amplifier A3 are configured to receive the power supply voltage. An output end of the second voltage division circuit 41 is coupled to a first input end of the third operational amplifier A3. A second input end of the third operational amplifier A3 is configured to be coupled to the antenna and coupled to the ground end through the first capacitor C1. An output end of the third operational amplifier A3 is coupled to an output end of the overcurrent detection circuit 40 through the current-limiting resistor R13. Optionally, the first input end of the third operational amplifier A3 may be a non-inverting input end, and the second input end of the third operational amplifier A3 may be an inverting input end. In FIG. 5, the second indication signal is represented as ANT_OC.

Optionally, the second voltage division circuit 41 may include an eleventh resistor R11 and a twelfth resistor R12. One end of the eleventh resistor R11 is used as the input end of the second voltage division circuit 41. The other end of the eleventh resistor R11 and one end of the twelfth resistor R12 are coupled and used as the output end of the second voltage division circuit 41. The other end of the twelfth resistor R12 is coupled to the ground end GND. A resistance value of the eleventh resistor R11 and a resistance value of the twelfth resistor R12 may be set, to set a proper threshold voltage. The threshold voltage may also be referred to as an overcurrent point voltage.

In the antenna detection circuit, the second voltage division circuit 41 in the overcurrent detection circuit 40 may divide the power supply voltage to generate the threshold voltage. The third operational amplifier A3 may compare the coupling point voltage of the antenna with the threshold voltage, to output the second indication signal indicating that an overcurrent occurs in the antenna. In other words, the overcurrent detection circuit 40 may compare the coupling point voltage of the antenna with the threshold voltage, to determine whether an overcurrent occurs in the antenna. This ensures accuracy of antenna detection, improves safety and reliability of the device, and avoids a user safety risk caused by a short circuit.

Further, as shown in FIG. 4, the antenna detection circuit may further include a short-circuit detection circuit 50, and an input end of the short-circuit detection circuit 50 is configured to be coupled to the antenna. The short-circuit detection circuit 50 is configured to detect the coupling point voltage of the antenna, and perform voltage division and sampling processing on the coupling point voltage, to output a third indication signal, where the third indication signal indicates whether the antenna is in a short-circuited state (which may also be referred to as whether the antenna is short-circuited). For example, when the third indication signal is at a low level (or referred to as when a voltage value corresponding to the third indication signal is 0), the third indication signal may indicate that the antenna is in the short-circuited state; or when the third indication signal is at a high level (or referred to as when the voltage value corresponding to the third indication signal is greater than 0), the third indication signal may indicate that the antenna is not in the short-circuited state.

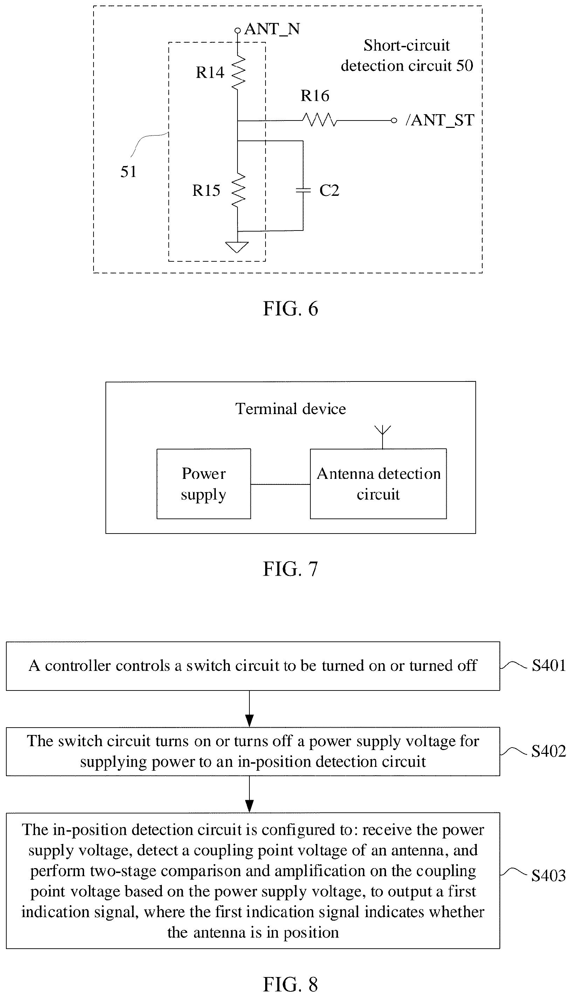

In a possible embodiment, as shown in FIG. 6, the short-circuit detection circuit 50 may include a third voltage division circuit 51, a sampling resistor R16, and a second capacitor C2. An input end of the third voltage division circuit 51 is configured to be coupled to the antenna, an output end of the third voltage division circuit 51 is coupled to one end of the sampling resistor R16 and one end of the second capacitor C2, the other end of the sampling resistor R16 is used as an output end of the short-circuit detection circuit 50, and the other end of the second capacitor C2 is coupled to the ground end GND. In FIG. 6, the third indication signal is represented as /ANT_ST.

Optionally, the third voltage division circuit 51 may include a fourteenth resistor R14 and a fifteenth resistor R15. One end of the fourteenth resistor R14 is used as the input end of the third voltage division circuit 51, the other end of the fourteenth resistor R14 and one end of the fifteenth resistor R15 are coupled and used as the output end of the third voltage division circuit 51, and the other end of the fifteenth resistor R15 is coupled to the ground end GND.

In the antenna detection circuit, the short-circuit detection circuit 50 is equivalent to a voltage collection circuit, and is configured to collect the coupling point voltage of the antenna. When the antenna is short-circuited, a coupling point of the antenna is grounded, and the short-circuit detection circuit 50 detects that the coupling point voltage of the antenna is 0, so that the short-circuit detection circuit 50 outputs a low voltage. When the antenna is not short-circuited, the coupling point of the antenna has a specific potential, and the short-circuit detection circuit 50 detects that the coupling point voltage of the antenna is not 0, so that the short-circuit detection circuit 50 outputs a high voltage. In this way, the short-circuit detection circuit 50 may detect whether the coupling point voltage of the antenna is 0, to determine whether the antenna is short-circuited. This ensures accuracy of antenna detection, improves safety and reliability of the device, and avoids a user safety risk caused by a short circuit.

It may be understood that structures of the in-position detection circuit 30, the sampling circuit 31, the first-stage operational amplifier circuit 32, the second-stage operational amplifier circuit 33, the overcurrent detection circuit 40, and the short-circuit detection circuit 50 shown in the foregoing embodiments are merely examples. The foregoing circuits may alternatively be implemented by using a circuit of another structure having a same or similar function. The foregoing examples do not constitute a limitation on embodiments of this application.

Further, the controller 10 is further configured to: receive an indication signal, and control, based on the indication information, the switch circuit 20 to be turned on or turned off, where the indication signal includes at least one of the first indication signal, the second indication signal, or the third indication signal. In this way, the controller 10 may control, based on the received indication signal, the switch circuit 20 to be turned on or turned off. In other words, the control signal is generated based on the indication signal, so that the control signal is used to control the switch circuit 20 to be turned on or turned off. In addition, the controller 10 may further send feedback information to a back-end circuit, to feed back various states of the antenna to the back-end circuit. This facilitates protection of the back-end circuit.

In this embodiment of this application, the controller 10 may receive the first indication signal that indicates whether the antenna is in position, the second indication signal that indicates whether an overcurrent occurs in the antenna, and the third indication signal that indicates whether the antenna is short-circuited, so that the controller 10 can control, based on the received indication signal, the switch circuit 20 to be turned on or turned off. For example, the switch circuit 20 is turned off when a short circuit or an overcurrent occurs in the antenna. This improves safety and reliability of the antenna and a terminal device in which the antenna detection circuit is used.

Based on this, an embodiment of this application further provides a terminal device. As shown in FIG. 7, the terminal device includes a power supply and an antenna detection circuit. The power supply is configured to provide a power supply voltage for the antenna detection circuit. The antenna detection circuit may be any antenna detection circuit provided above. Optionally, the terminal device may be an in-vehicle device.

On another side of this application, a vehicle is further provided, and the vehicle may include the in-vehicle device provided above. Optionally, the vehicle may be an autonomous driving vehicle, and has a vehicle positioning function.

It may be understood that the foregoing detailed description of the antenna detection circuit may be correspondingly sited in embodiments corresponding to the terminal device and the vehicle. Details are not described herein again in this embodiment of this application.

FIG. 8 shows an antenna detection method further provided in an embodiment of this application. The method may be applied to the antenna detection circuit provided above. The antenna detection circuit includes a controller, a switch circuit, and an in-position detection circuit. The in-position detection circuit is configured to be coupled to an antenna. Antenna detection may include the following steps.

S401: The controller controls the switch circuit to be turned on or turned off.

For example, the controller may output a control signal, and the control signal may be used to control the switch circuit to be turned on or turned off. For example, when the control signal is at a high level, the control signal may be used to control the switch circuit to be turned on; or when the control signal is at a low level, the control signal may be used to control the switch circuit to be turned off. Optionally, the controller may be a microcontroller unit MCU, or may be another component having a control function in the terminal device.

S402: The switch circuit turns on or turns off a power supply voltage for supplying power to the in-position detection circuit.

That the switch circuit turns on the power supply voltage for supplying power to the in-position detection circuit may also be referred to as that the switch circuit connects the in-position detection circuit to the power supply. In other words, when the switch circuit is in a turned-on state, the power supply voltage may supply power to the in-position detection circuit after passing through the switch circuit. Similarly, that the switch circuit turns off the power supply voltage for supplying power to the in-position detection circuit may also be referred to as that the switch circuit disconnects the in-position detection circuit from the power supply. In other words, when the switch circuit is in a turned-off state, the power supply voltage is turned off, thereby no longer supplying power to the in-position detection circuit.

S403: The in-position detection circuit receives the power supply voltage, detects a coupling point voltage of the antenna, and performs two-stage comparison and amplification on the coupling point voltage based on the power supply voltage, to output a first indication signal, where the first indication signal indicates whether the antenna is in position.

Performing two-stage comparison and amplification on the coupling point voltage may be: comparing coupling point voltages in different antenna states with different thresholds through two-stage comparison and amplification. In addition, the in-position status of the antenna includes two states: an in-position state and an out-of-position state. That the antenna is in position may mean that the antenna is normally connected, and that the antenna is out of position may mean that the antenna is abnormally connected or disconnected. The first indication signal indicates whether the antenna is in position. For example, when the first indication signal is at a low level, the first indication signal may indicate that the antenna is in position; or when the first indication signal is at a high level, the first indication signal may indicate that the antenna is out of position.

In a possible embodiment, the in-position detection circuit includes a sampling circuit, a first-stage operational amplifier circuit, and a second-stage operational amplifier circuit. Correspondingly, S403 may specifically include: The sampling circuit samples the coupling point voltage of the antenna, and generates a first comparison voltage based on the power supply voltage; the first-stage operational amplifier circuit compares the coupling point voltage with the first comparison voltage, and performs amplification, to output a first amplified voltage; and the second-stage operational amplifier circuit generates a second comparison voltage based on the power supply voltage, compares the first amplified voltage with the second comparison voltage, and performs amplification, to output the first indication signal.

The foregoing in-position detection circuit implements a current hysteresis comparison function. In other words, current hysteresis comparison is implemented for the in-position detection current. In this way, the in-position detection current has a hysteresis range. The hysteresis range can raise a criterion for switching the in-position status of the antenna, so that a determining result is more accurate, and safety is higher. For example, the hysteresis range may be 4 mA to 10 mA. When the in-position detection current increases from a smaller value to 10 mA (> 10 mA), the in-position detection circuit determines that the antenna switches from an out-of-position state to an in-position state. When the in-position detection current decreases from a larger value to 4 mA (< 4 mA), the in-position detection circuit determines that the antenna switches from the in-position state to the out-of-position state.

In this embodiment of this application, after a current generated by the antenna passes through a first resistor and a second resistor in the sampling circuit, collected weak current signals are converted into voltage signals (namely, the coupling point voltage and the first comparison voltage), and the first-stage operational amplifier circuit compares the converted voltage signals and performs amplification. When the first-stage operational amplifier circuit outputs a high voltage, a transistor in the switch amplifier circuit is conducted, and the second-stage operational amplifier circuit outputs a low voltage. In this case, it may be determined that the antenna is in position. When the first-stage operational amplifier circuit outputs a low voltage, the transistor in the switch amplifier circuit is cut off, and the second-stage operational amplifier circuit outputs a high voltage. In this case, it may be determined that the antenna is out of position. In this way, two-stage comparison and amplification is performed on the detected coupling point voltage of the antenna, to determine, based on a comparison result, whether the antenna is in position. This ensures accuracy of antenna detection and improves device safety.

Further, the antenna detection circuit further includes an overcurrent detection circuit, and the overcurrent detection circuit is configured to be coupled to the antenna. Correspondingly, the method further includes: The switch circuit turns on or turns off the power supply voltage for supplying power to the overcurrent detection circuit; and the overcurrent detection circuit receives the power supply voltage, detects the coupling point voltage of the antenna, generates a threshold voltage based on the power supply voltage, and compares the coupling point voltage with the threshold voltage, to output a second indication signal, where the second indication signal indicates whether the antenna is in an overcurrent state. In this way, the overcurrent detection circuit may compare the coupling point voltage of the antenna with the threshold voltage, to determine whether an overcurrent occurs in the antenna. This ensures accuracy of antenna detection, improves safety and reliability of the device, and avoids a user safety risk caused by a short circuit.

Further, the antenna detection circuit further includes a short-circuit detection circuit, and the short-circuit detection circuit is configured to be coupled to the antenna. Correspondingly, the method further includes: The short-circuit detection circuit detects the coupling point voltage of the antenna, and performs voltage division and sampling processing on the coupling point voltage to output a third indication signal, where the third indication signal indicates whether the antenna is in a short-circuited state. In this way, the short-circuit detection circuit may detect whether the coupling point voltage of the antenna is 0, to determine whether the antenna is short-circuited. This ensures accuracy of antenna detection, improves safety and reliability of the device, and avoids a user safety risk caused by a short-circuit.

In a possible embodiment, that the controller controls the switch circuit to be turned on or turned off includes: The controller receives an indication signal, and controls, based on the indication information, the switch circuit to be turned on or turned off, where the indication signal includes at least one of the first indication signal, the second indication signal, or the third indication signal.

In this embodiment of this application, the controller may receive the first indication signal that indicates whether the antenna is in position, the second indication signal that indicates whether an overcurrent occurs in the antenna, and the third indication signal that indicates whether the antenna is short-circuited, so that the controller can control, based on the received indication signal, the switch circuit to be turned on or turned off. For example, the switch circuit is turned off when a short circuit or an overcurrent occurs in the antenna. This improves safety and reliability of the antenna and a terminal device in which the antenna detection circuit is used.

It may be understood that the foregoing detailed description of the antenna detection circuit may be correspondingly sited in embodiments corresponding to the antenna detection method. Details are not described herein again in this embodiment of this application.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An antenna detection circuit, wherein the antenna detection circuit comprises a controller, a switch circuit, and an in-position detection circuit, an output end of the controller is coupled to a control end of the switch circuit, an input end of the switch circuit is configured to be coupled to a power supply, an output end of the switch circuit is coupled to a first input end of the in-position detection circuit, and a second input end of the in-position detection circuit is configured to be coupled to an antenna;
the controller is configured to control the switch circuit to be turned on or turned off;
the switch circuit is configured to turn on or turn off a power supply voltage for supplying power to the in-position detection circuit; and
the in-position detection circuit is configured to: receive the power supply voltage, detect a coupling point voltage of the antenna, and perform two-stage comparison and amplification on the coupling point voltage based on the power supply voltage, to output a first indication signal, wherein the first indication signal indicates whether the antenna is in position.

2. The antenna detection circuit according to claim 1, wherein the in-position detection circuit comprises a sampling circuit, a first-stage operational amplifier circuit, and a second-stage operational amplifier circuit; and
a first end of the sampling circuit and a first input end of the second-stage operational amplifier circuit are coupled and used as the first input end of the in-position detection circuit, a second end and a third end of the sampling circuit are respectively coupled to a first input end and a second input end of the first-stage operational amplifier circuit, an output end of the first-stage operational amplifier circuit is coupled to a second input end of the second-stage operational amplifier circuit, an output end of the second-stage operational amplifier circuit is used as an output end of the in-position detection circuit, and the second end of the sampling circuit is further configured to be coupled to the antenna.

3. The antenna detection circuit according to claim 2, wherein
the sampling circuit is configured to: sample the coupling point voltage of the antenna, and generate a first comparison voltage based on the power supply voltage;
the first-stage operational amplifier circuit is configured to: compare the coupling point voltage with the first comparison voltage, and perform amplification, to output a first amplified voltage; and
the second-stage operational amplifier circuit is configured to: generate a second comparison voltage based on the power supply voltage, compare the first amplified voltage with the second comparison voltage, and perform amplification, to output the first indication signal.

4. The antenna detection circuit according to claim 2 or 3, wherein the sampling circuit comprises a first resistor and a second resistor, one end of the first resistor and one end of the second resistor are coupled and used as the first end of the sampling circuit, the other end of the first resistor is used as the second end of the sampling circuit, and the other end of the second resistor is used as the third end of the sampling circuit.

5. The antenna detection circuit according to any one of claims 2 to 4, wherein the first-stage operational amplifier circuit comprises a first operational amplifier and a switch amplifier circuit; and
a first input end and a second input end of the first operational amplifier are respectively used as the first input end and the second input end of the first-stage operational amplifier circuit, an output end of the first operational amplifier is coupled to a control end of the switch amplifier circuit, the second input end of the first operational amplifier is coupled to an input end of the switch amplifier circuit, a power supply end of the first operational amplifier is configured to receive the power supply voltage, and an output end of the switch amplifier circuit is used as the output end of the first-stage operational amplifier circuit.

6. The antenna detection circuit according to claim 5, wherein the switch amplifier circuit comprises a first transistor, a third resistor, a fourth resistor, and a fifth resistor; and
a control terminal of the first transistor is coupled to the control end of the switch amplifier circuit through the third resistor, the control end of the first transistor is coupled to a ground end through the fourth resistor, a first terminal of the first transistor is coupled to the ground end through the fifth resistor, and a second terminal of the first transistor is coupled to the input end of the switch amplifier circuit.

7. The antenna detection circuit according to any one of claims 2 to 6, wherein the second-stage operational amplifier circuit comprises a first voltage division circuit and an operational amplifier circuit; and
an input end of the first voltage division circuit is used as the first input end of the second-stage operational amplifier circuit, an output end of the first voltage division circuit is coupled to a first input end of the operational amplifier circuit, a second input end of the operational amplifier circuit is used as the second input end of the second-stage operational amplifier circuit, and an output end of the operational amplifier circuit is used as the output end of the second-stage operational amplifier circuit.

8. The antenna detection circuit according to claim 7, wherein the first voltage division circuit comprises a sixth resistor, a seventh resistor, and an eighth resistor; and
one end of the sixth resistor is used as the input end of the first voltage division circuit, the other end of the sixth resistor is coupled to one end of the seventh resistor and one end of the eighth resistor, the other end of the seventh resistor is coupled to the ground end, and the other end of the eighth resistor is used as the output end of the first voltage division circuit.

9. The antenna detection circuit according to claim 7 or 8, wherein the operational amplifier circuit comprises a second operational amplifier, a ninth resistor, and a tenth resistor; and
a first input end and a second input end of the second operational amplifier are respectively used as the first input end and the second input end of the operational amplifier circuit, one end of the ninth resistor is coupled to the first input end of the second operational amplifier, an output end of the second operational amplifier is coupled to the other end of the ninth resistor and one end of the tenth resistor, the other end of the tenth resistor is used as the output end of the operational amplifier circuit, and a power supply end of the second operational amplifier is configured to receive the power supply voltage.

10. The antenna detection circuit according to any one of claims 1 to 9, wherein the antenna detection circuit further comprises an overcurrent detection circuit, an input end of the overcurrent detection circuit is configured to be coupled to the antenna, and a power supply end of the overcurrent detection circuit is configured to receive the power supply voltage;
the switch circuit is further configured to turn on or turn off the power supply voltage for supplying power to the overcurrent detection circuit; and
the overcurrent detection circuit is configured to: receive the power supply voltage, detect the coupling point voltage of the antenna, generate a threshold voltage based on the power supply voltage, and compare the coupling point voltage with the threshold voltage, to output a second indication signal, wherein the second indication signal indicates whether the antenna is in an overcurrent state.

11. The antenna detection circuit according to claim 10, wherein the overcurrent detection circuit comprises a third operational amplifier, a second voltage division circuit, a current-limiting resistor, and a first capacitor; and
both an input end of the second voltage division circuit and a power supply end of the third operational amplifier are configured to receive the power supply voltage, an output end of the second voltage division circuit is coupled to a first input end of the third operational amplifier, a second input end of the third operational amplifier is configured to be coupled to the antenna and coupled to the ground end through the first capacitor, and an output end of the third operational amplifier is coupled to an output end of the overcurrent detection circuit through the current-limiting resistor.

12. The antenna detection circuit according to any one of claims 1 to 11, wherein the antenna detection circuit further comprises a short-circuit detection circuit, and an input end of the short-circuit detection circuit is configured to be coupled to the antenna; and
the short-circuit detection circuit is configured to: detect the coupling point voltage of the antenna, and perform voltage division and sampling processing on the coupling point voltage, to output a third indication signal, wherein the third indication signal indicates whether the antenna is in a short-circuited state.

13. The antenna detection circuit according to claim 12, wherein the short-circuit detection circuit comprises a third voltage division circuit, a sampling resistor, and a second capacitor; and
an input end of the third voltage division circuit is configured to be coupled to the antenna, an output end of the third voltage division circuit is coupled to one end of the sampling resistor and one end of the second capacitor, the other end of the sampling resistor is used as an output end of the short-circuit detection circuit, and the other end of the second capacitor is coupled to the ground end.

14. The antenna detection circuit according to any one of claims 1 to 13, wherein
the controller is further configured to: receive an indication signal, and control, based on the indication information, the switch circuit to be turned on or turned off, wherein the indication signal comprises at least one of the first indication signal, the second indication signal, or the third indication signal.

15. The antenna detection circuit according to any one of claims 1 to 14, wherein the switch circuit comprises a second transistor, a third capacitor, and an RC circuit; and
the third capacitor is coupled between a control terminal and a first terminal of the second transistor, the RC circuit is coupled between the control terminal and a second terminal of the second transistor, the first terminal of the second transistor is further configured to output the power supply voltage, the second terminal of the second transistor is further configured to receive the power supply voltage, and the control end of the second transistor is further configured to receive a control signal.

16. An antenna detection method, applied to an antenna detection circuit, wherein the antenna detection circuit comprises a controller, a switch circuit, and an in-position detection circuit, the in-position detection circuit is configured to be coupled to an antenna, and the method comprises:
controlling, by the controller, the switch circuit to be turned on or turned off;
turning on or turning off, by the switch circuit, a power supply voltage for supplying power to the in-position detection circuit; and
receiving, by the in-position detection circuit, the power supply voltage, detecting a coupling point voltage of the antenna, and performing two-stage comparison and amplification on the coupling point voltage based on the power supply voltage, to output a first indication signal, wherein the first indication signal indicates whether the antenna is in position.

17. The antenna detection method according to claim 16, wherein the in-position detection circuit comprises a sampling circuit, a first-stage operational amplifier circuit, and a second-stage operational amplifier circuit;
sampling, by the sampling circuit, the coupling point voltage of the antenna, and generating a first comparison voltage based on the power supply voltage;
comparing, by the first-stage operational amplifier circuit, the coupling point voltage with the first comparison voltage, and performing amplification to output a first amplified voltage; and
generating, by the second-stage operational amplifier circuit, a second comparison voltage based on the power supply voltage, comparing the first amplified voltage with the second comparison voltage, and performing amplification, to output the first indication signal.

18. The antenna detection method according to claim 16 or 17, wherein the antenna detection circuit further comprises an overcurrent detection circuit, the overcurrent detection circuit is configured to be coupled to the antenna, and the method further comprises:
turning on or turning off, by the switch circuit, the power supply voltage for supplying power to the overcurrent detection circuit; and
receiving, by the overcurrent detection circuit, the power supply voltage, detecting the coupling point voltage of the antenna, generating a threshold voltage based on the power supply voltage, and comparing the coupling point voltage with the threshold voltage, to output a second indication signal, wherein the second indication signal indicates whether the antenna is in an overcurrent state.

19. The antenna detection method according to any one of claims 16 to 18, wherein the antenna detection circuit further comprises a short-circuit detection circuit, the short-circuit detection circuit is configured to be coupled to the antenna, and the method further comprises:
detecting, by the short-circuit detection circuit, the coupling point voltage of the antenna, and performing voltage division and sampling processing on the coupling point voltage to output a third indication signal, wherein the third indication signal indicates whether the antenna is in a short-circuited state.

20. The antenna detection method according to any one of claims 16 to 19, wherein controlling, by the controller, the switch circuit to be turned on or turned off comprises:
receiving, by the controller, an indication signal, and controlling, based on the indication information, the switch circuit to be turned on or turned off, wherein the indication signal comprises at least one of the first indication signal, the second indication signal, or the third indication signal.

21. An in-vehicle device, wherein the in-vehicle device comprises a power supply and the antenna detection circuit according to any one of claims 1 to 15, and the power supply is configured to provide a power supply voltage for the antenna detection circuit.

22. A vehicle, wherein the vehicle comprises the in-vehicle device according to claim 21.
